Europäisches Patentamt

European Patent Office

Office européen des brevets

(19)

(11) Veröffentlichungsnummer: **0 301 254**
**A2**

(12) **EUROPÄISCHE PATENTANMELDUNG**

(21) Anmeldenummer: 88110309.7

(51) Int. Cl.4: **G01R 31/28**

(22) Anmeldetag: 28.06.88

(30) Priorität: 30.07.87 DE 3725313

(43) Veröffentlichungstag der Anmeldung:
01.02.89 Patentblatt 89/05

(84) Benannte Vertragsstaaten:
**BE DE FR GB NL**

(71) Anmelder: **Siemens Aktiengesellschaft Berlin
und München**
**Wittelsbacherplatz 2**
**D-8000 München 2(DE)**

(72) Erfinder: **Brust, Hans-Detlef**
**Martin-Luther-Strasse 2**
**D-6602 Dudweiler(DE)**

(54) **Spannungsmessung mit einer Elektronensonde durch Messungen im Frequenzbereich mittels eines modulierten Primärstrahls.**

(57) Zur zeitlichen Detektion und Abbildung eines Punktes einer Probe, der ein Signal wenigstens einer bestimmten Frequenz führt, wird in einem Mikroskop ein sekundäres Signal erzeugt. Ein Primärstrahl (PE) wird mit wenigstens einer bestimmten Frequenz (fb) moduliert, wobei diese Frequenz (fb) verschieden von wenigstens einer Frequenz (fs) des Signals ist, das der Punkt führt. Das sich ergebende Signal wird dadurch auf eine bestimmte Zwischenfrequenz (df) gemischt und schließlich in einer Meßverarbeitungsanordnung (MV, MV') in zwei im Frequenzbereich befindliche Merkmale des sekundären Signals demoduliert. Durch eine Fourier-Rücktransformation im Rechner (R) wird anschließend das zeitliche Signal der Probe rückgewonnen.

FIG 2

EP 0 301 254 A2

## Spannungsmessung mit einer Elektronensonde durch Messungen im Frequenzbereich mittels eines modulierten Primärstrahls.

Die Erfindung betrifft eine Spannungsmessung mit einer Elektronensonde durch Messungen im Frequenzbereich mittels eines modulierten Primärstrahls nach dem Oberbegriff des Anspruchs 1.

Es sind bisher eine Vielzahl von Methoden bekannt, die Signalverläufe hochfrequenter, periodischer Meßsignale mit dem Elektronenstrahl zu erfassen. Eine Zusammenfassung der zur Zeit gängigen Testverfahren ist in der Veröffentlichung "Microelectronic Engineering" 4 (1986) Seiten 77 bis 106 "Electron Beam Testing" von E. Wolfgang, insbesondere auf Seite 83, wiedergegeben. Man unterscheidet Messungen, die im Zeitbereich und solche die im Frequenzbereich erfolgen. Zum ersten gehört beispielsweise das "voltage coding" (siehe auch "Scanning Electron Microscopy" 1975 (Part I) Proc. of the Eigth Annual Scanning Electron Microscope Symposium, Chicago, IIT Research Institute, Seiten 465 bis 471) oder das "Logic State Mapping" (siehe auch US-Patentschrift 4 223 220), während zu letzterem das sogenannte "Frequency-Mapping-Verfahren" oder das in dieser Erfindung ausgeführte Meßverfahren gehören.

Bei beiden zuletzt genannten Verfahren richtet man den Elektronenstrahl auf den Meßpunkt und mißt das Frequenzspektrum des dort anliegenden Signals. Die Offenlegungsschrift DE 35 19 392 A1 gibt ein Verfahren an, bei der eine Signalkomponente im Frequenzbereich gewonnen wird. Durch Variation der Mittenfrequenz eines durchstimmbaren Filters kann man das in Frage kommende Frequenzspektrum durchfahren und so bei unbekannter Frequenz die auf einem Meßpunkt, beispielsweise einer Leiterbahn in einem integrierten Halbkreis, auftretenden Frequenzen feststellen. Die Grundlagen des "Frequency-Mapping"-Verfahrens sind in der Veröffentlichung "Microelectronic Engineering", Vol. 2, No. 4, 1985, "Frequency Tracing and Mapping in Theory and Practice" Nh 1 Sti/01.06.1987 von H. D. Brust und F. Fox, Seiten 304 bis 311 und in der Offenlegungsschrift DE 35 19 401 A1 wiedergegeben. Beim "Frequency-Mapping"-Verfahren muß das Strahlaustastsystem nicht mit kurzen elektrischen Pulsen angesteuert werden, wie beispielsweise beim "Logic State Mapping"-Verfahren, sondern es genügt, eine Wechselspannung mit einer bestimmten Frequenz anzulegen, um den Primärstrahl zu modulieren. Im Prinzip ist auch die Ansteuerung mit einer rein sinusförmigen Spannung möglich. Durch geringen Frequenzversatz derjenigen Frequenz, mit der der Primärstrahl moduliert wird, gegenüber der Frequenz eines gesuchten Signals erreicht man, daß durch die Wechselwirkung des in der Probe ablaufenden periodischen Vorgangs mit dem Primärstrahl das gesuchte Signal stets auf eine feste Zwischenfrequenz gemischt wird. Diese feste Zwischenfrequenz kann sodann leicht ausgefiltert und danach demoduliert werden. Da die Signalkette eines Rasterelektronenmikroskops nur die relativ niedrige feste Zwischenfrequenz übertragen muß, können in einer Probe Signale sehr hoher Frequenz detektiert bzw. abgebildet werden. Durch Wobbeln derjenigen Frequenz, mit der der Primärstrahl moduliert wird, kann man das in Frage kommende Frequenzspektrum durchfahren und kann so bei unbekannter Frequenz eines gesuchten Signals die in einem Punkt der Probe auftretenden Frequenzen feststellen.

Bei Messungen im Zeitbereich ist es erforderlich, das Strahlaustastsystem mit möglichst kurzen elektrischen Impulsen anzusteuern. Dies stößt vor allem bei höheren Frequenzen und damit kürzeren Zeiten auf erhebliche Probleme. Für sehr kurze Pulse (100 Pikosekunden bis 1 Nanosekunde) müssen spezielle Pulsgeneratoren benützt werden. Die Steuerung des Auslösezeitpunkts des Elektronenpulses, die sogenannten Phasensteuerung, kann beispielsweise dabei über eine steuerbare Verzögerungsleitung erfolgen. Aber auch dies stößt bei sehr kurzen Zeiten auf erhebliche Probleme. Andererseits erhält man durch die Anwendung des "Frequency-Mapping"-Verfahrens lediglich eine Aussage über die Frequenz, seine Oberwellen, sowie über die zugehörigen Amplituden der Frequenzkomponenten des zu messenden Signals.

Der Erfindung liegt die Aufgabe zugrunde den zeitlichen Signalverlauf hochfrequenter periodischer Meßsignale mit dem Elektronenstrahl zu erfassen und wiederzugeben.

Diese Aufgabe wird erfindungsgemäß dadurch gelöst, daß das zeitliche Meßsignal entsprechend dem kennzeichnenden Teil des Patentanspruchs 1 im Frequenzbereich erfaßt und anschließend wieder in den Zeitbereich rücktransformiert wird.

Weitere Ausführungen sowie Realisierungen zum erfindungsgemäßen Verfahren sind Gegenstand der Unteransprüche und werden dort näher erläutert.

Die mit der Erfindung erzielten Vorteile liegen darin, daß durch das Verfahren das Puls-Pause-Verhältnis von ca. 1:1000 bei früheren Meßverfahren im Zeitbereich auf ca. 1:1 verbessert werden kann, was zu einem verbesserten Signalrauschverhältnis führt. Das Verfahren arbeitet schnell und belastet die Probe dadurch wenig und ist überdies bis zu sehr hohen Arbeitsfrequenz einsetzbar, was ein Routineeinsatz eines Verfahrens nach der Erfindung möglich macht.

Obwohl sich die folgenden Ausführungsbeispiele auf ein Elektronenmikroskop beziehen, ist die Erfindung so zu verstehen, daß anstelle von Elektronen auch Ionen oder andere Korpuskel verwendet werden können, und zwar sowohl als Primärkorpuskel als auch als Sekundärkorpuskel. Insbesondere kommen als Korpuskel auch Photonen in Betracht.

Bei den untersuchten Proben handelt es sich bei den zwei Ausführungsbeispielen um eine integrierte Schaltung. In der integrierten Schaltung läuft jeweils ein periodischer Vorgang ab, z.B. arbeitet ein Mikroprozessor wiederholt eine Programmschleife ab, so daß auf den Leiterbahnen der integrierten Schaltung periodisch elektrische Signale verschiedener Frequenzen auftreten. Bestrahlt man eine solche Leiterbahn mit einem Primärelektronenstrahl, so lösen die Primärelektronen beim Auftreffen auf die Probenoberfläche niederenergetische Sekundärelektronen aus, die von einem Detektor abgesaugt und registriert werden können. Die Sekundärelektronen werden dabei von den durch die elektrischen Signale auf der Leiterbahn hervorgerufenen elektrischen Felder bzw. durch die Potentiale der Leiterbahnen selbst über der Probenoberfläche beeinflußt - eine Wechselwirkung, die man als Potentialkontrast bezeichnet.

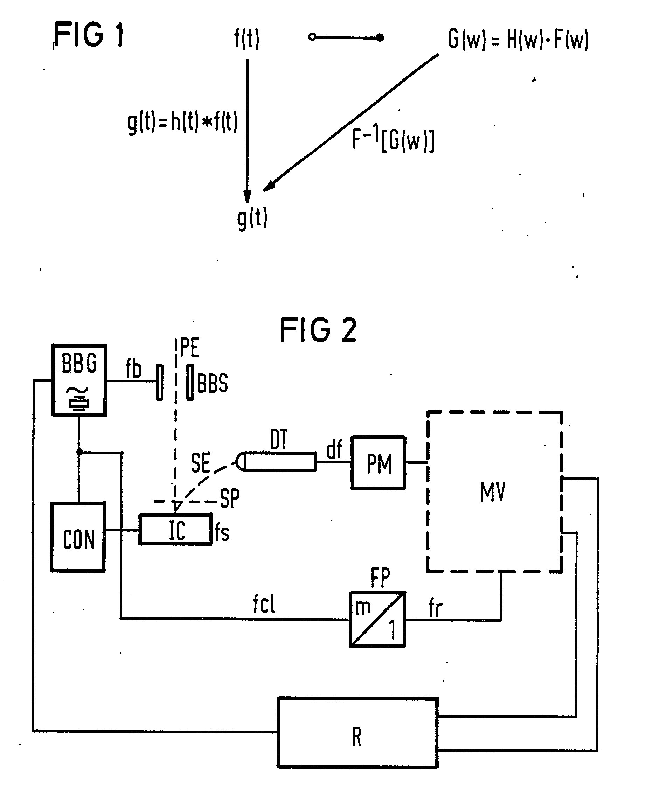

Ein Ausführungsbeispiel der Erfindung ist in Figur 2 dargestellt und wird im folgenden näher beschrieben. Es zeigen

Figur 1 die prinzipiellen Möglichkeiten der Spannungsmessung mit der Elektronensonde im Frequenzbereich oder im Zeitbereich,

Figur 2 eine Vorrichtung zum erfindungsgemäßen Verfahren, wobei die Spannungsmessung mit der Elektronensonde im Frequenzbereich erfolgt,

Figur 3, 4 und 5 eine Realisierung der Meßverarbeitungsanordnung nach Figur 2.

In Figur 1 wird mit f(t) das unbekannte Signal auf der Probenoberfläche bezeichnet. Das gemessene Signal g(t) kann entweder im Zeitbereich gemessen werden, was rechnerisch in erster Näherung eine Faltung aus dem unbekannten Signal f(t) mit dem Signal der Primärelektroden h(t) bedeutet, oder das unbekannte Signal f(t) kann im Frequenzbereich erfaßt und über eine Fourier-Rücktransformation in die Funktion g(t) umgewandelt werden. Im letzteren Fall ergibt sich das zu messende Signal im Frequenzbereich G(w) aus einem Produkt aus dem Signal der Primärelektronen im Frequenzbereich H(w) und dem zu messenden Signal im Frequenzbereich F(w).

Zur Ausführung der Fourier-Rücktransformation ist es erforderlich, das Spektrum G(w) eindeutig zu bestimmen, d.h. die einzelnen Spektralkomponenten müssen nach Betrag und Phase bzw. Real- und Imaginärteil oder allgemeiner nach zwei Quadraturkomponenten gemessen werden.

Figur 2 zeigt eine Vorrichtung zur zeitlichen Detektion und/oder Abbildung eines Meßpunktes oder einer Leiterbahn, die ein Signal mit einer bestimmten Frequenz führen, so wie sie zur Durchführung eines Verfahrens nach dem oben angegebenen Stand der Technik verwendet wird. Aus einer Elektronenquelle treten Primärelektronen PE aus, die auf einen Meßpunkt oder eine Leiterbahn innerhalb eines integrierten Schaltkreises IC auftreffen und dort Sekundärelektronen SE auslösen. Diese Sekundärelektronen SE werden in einem Detektor DT nachgewiesen. In Abhängigkeit von dem Sekundärelektronenstrom, der auf den Detektor DT auftrifft, wird in diesem Detektor DT ein Sekundärelektronensignal erzeugt, das zu einem Photomultiplier PM geführt und dort verstärkt wird. Das im Photomultiplier PM verstärkte Sekundärelektronensignal wird über einen eventuell dazwischengeschalteten Vorverstärker an die Meßverarbeitungsanordnung MV weitergeleitet.

Der Elektronenstrahl PE wird mit Hilfe eines Strahlaustastsystems BBS mit einer bestimmten Frequenz ausgetastet. Ein geeignetes Strahlaustastsystem ist beispielsweise aus der US-PS 41 69 229 bekannt. Das Strahlaustastsystem BBS wird mit der Frequenz fb von einem Generator BBG angesteuert. Anstelle des Strahlaustastsystems BBS kann auch jedes andere System treten, das eine Intensitätsmodulation des Primärelektronenstrahls bewirkt. Hierfür kommt z.B. auch der Wehnelt-Zylinder der Elektronenquelle in Betracht. Die integrierte Schaltung IC wird von einer Ansteuerung CON aus mit Eingangssignalen angesteuert. Die Frequenz fb ist gegenüber der Frequenz fs, die ein gesuchtes Signal in einem Meßpunkt aufweisen soll, in die Frequenz df versetzt. Die Zahl df ist gleich dem Absolutbetrag der Differenz aus den Zahlen fb und fs. Bei der Modulation des Primärstrahls PE mit einem Signal aus dem Strahlaustastsystem BBS und der Frequenz fs entsteht ebenfalls ein Signal mit einer Summenfrequenz aus fb und fs. Dieses Signal wird jedoch aufgrund einer geringeren Bandbreite des Detektors DT nicht übertragen. Wenn der Meßpunkt ein Signal mit der Frequenz fs führt und wenn die Primärelektronen mit der Frequenz fb gepulst werden, enthält das Sekundärelektronensignal, wie es über den Detektor DT und über den Photomultiplier PM gelangt ein Signal mit der Frequenz df.

Will man diese Messung nicht nur an einem Meßpunkt durchführen, so muß man den Primärstrahl PE über die Probe hinwegbewegen. Der Primärelektronenstrahl muß dabei natürlich nicht unbedingt entlang einer Linie gerastert werden. Vielmehr kann der Primärelektronenstrahl PE auch ständig zwischen mehreren Meßpunkten hin- und herspringen. In beiden Fällen soll die Ablenkung des Primärelektronenstrahls über eine zusammengehörende Gruppe von Meßpunkten hinweg so erfolgen. Daß sich während des Abtastens der gesamten Gruppe von zusammengehörenden Meßpunkten die Frequenz fb nicht ändert.

Die Geschwindigkeitsverhältnisse von Primärstrahlablenkung und Veränderung der Frequenz fb können jedoch auch umgekehrt werden. Die Primärstrahlablenkung, die dabei entweder kontinuierlich oder durch Springen zwischen mehreren Meßpunkten erfolgen. Dazu wird z.B. der Primärelektronenstrahl zunächst auf einen Meßpunkt positioniert und sodann der interessierende Frequenzbereich mit Hilfe des Rechners R überstrichen. Daraufhin wird der Primärelektronenstrahl kontinuierlich oder sprungweise auf einen weiteren Meßpunkt positioniert, wo erneut die Austastfrequenz fb über den interessierenden Frequenzbereich hinweg durchgewobbelt wird.

Der Rechner R ist zum einen mit dem Beam-blanking-Generator BBG, zum anderen mit der Meßverarbeitungsanordnung MV verbunden. Über die zuerst genannte Verbindung ist es möglich, die Frequenz fb über den Beam-blanking-Generator BBG zu bestimmen. Außerdem hat der Rechner R die Aufgabe, die zwei ermittelten Merkmale des sekundären Signals im Frequenzbereich durch eine Fourier-Rücktransformation in ein zeitliches Signal umzuwandeln. Da die Frequenz df, wie oben bereits erwähnt, gleich dem Absolutbetrag der Differenz aus den Frequenzen fb und fs ist, ergibt sich für fb die Möglichkeit von fs - df und die Möglichkeit fs + df. Um eventuelle Störungen durch Signalfrequenzen zu erkennen und auszuschalten, ist es vorteilhaft, bei der Messung von beiden Möglichkeiten Gebrauch zu machen.

Anstelle des Rechners kann auch eine Steuereinheit zur Steuerung der Durchführung der Messung und eine festverdrahtete Einheit zur Durchführung der Fourier-Rücktransformation treten.

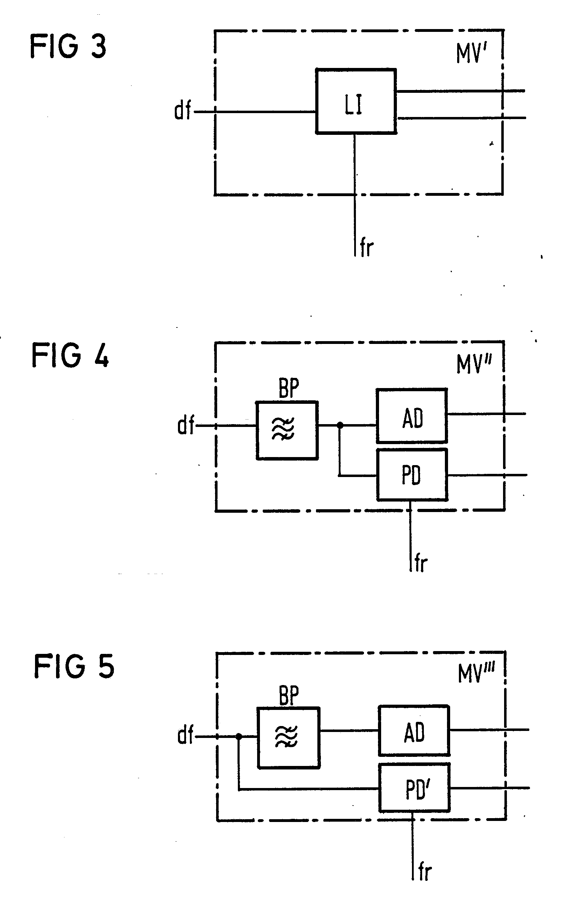

Die Meßverarbeitungsanordnung MV' nach Figur 3 zeigt eine Realisierung mit Hilfe eines Lock-in-Verstärkers (LI). Sie kann auch allgemeiner aus zwei phasenempfindlichen Detektoren bestehen. Lock-in-Verstärker und phasenempfindliche Detektoren sind dem Fachmann aus der Literatur bekannt. Als Lock-in-Verstärker kann beispielsweise ein Ithaco-Verstärker Typ 491A verwendet werden. Dem Lock-in-Verstärker LI muß dabei eine Referenzfrequenz fr zugeführt werden, durch die dann die auszufilternde Zwischenfrequenz df festgelegt wird. Lock-in-Verstärker liefern als Ausgangssignale dann gewöhnlich zwei Quadraturkomponenten und/oder Betrag und Phase der Eingangssignalkomponenten bei der auszufilternden Frequenz.

Figur 4 zeigt eine zweite Realisierungsmöglichkeit der Meßverarbeitungsanordnung MV aus Figur 2. Die Meßverarbeitungsanordnung MV'' besteht in diesem Falle aus einem Bandpaß BP mit nachgeschaltetem Amplituden- AD und Phasendemodulator PD. Der Bandpaß BP, der hinter dem Photomultiplier PM oder einem dazwischengeschalteten Vorverstärker angeordnet ist, weist als Mittenfrequenz die Frequenz df auf. Daher filtert das Bandpaß BP genau diese Frequenz df aus dem Frequenzspektrum des Sekundärelektronensignals aus. Der durch das Bandpaßfilter BP hindurchgelassene Anteil des Sekundärelektronensignals wird in einem Amplitudendemodulator AD und in einem parallel geschalteten Phasendemodulator PD demoduliert, so daß anschließend zwei Merkmale des sekundären Signals im Frequenzbereich vorliegen, nämlich der Betrag und die Phase des Signalanteils der Frequenz df. Normalerweise wird als Frequenzdemodulator PD eine PLL (phase locked loop)-Schaltung verwendet. PLL-Schaltungen sind dem Fachmann beispielsweise aus einem Frequenzsynthesesystem für Fernsehgeräte bekannt. Die PLL-Schaltung ermöglicht eine echte Synchrondemodulation. Dem Phasendemodulator PD kann zur Synchronisation ein Referenzsignal der Frequenz fr zugeführt werden. Im allgemeinen wird dabei fr gleich der Frequenz df sein. Da bei dieser Betriebsart der Beam-blanking-Generator BBG und die Ansteuerschaltung CON synchronisiert werden sollten und eine solche Synchronisation sehr einfach durch Muttertaktsignale einer Frequenz fcl erfolgen kann, ist es bei geschickter Wahl der Frequenz df leicht möglich, das Referenzsignal fr durch einfache Frequenzteilung mit Hilfe eines Frequenzteilers FP aus dem genannten Muttertaktsignal zu gewinnen, wie dies auch in Figur 2 dargestellt ist. Da der Wert der Frequenz df im Prinzip beliebig ist, solange die Frequenz nur niedrig genug bleibt, um noch vom Detektor DT und der nachfolgenden Signalkette übertragen zu werden, ist dies im allgemeinen die einfachste Möglichkeit zur Gewinnung von fr. Allerdings ist es auch möglich, die Referenzfrequenz aus der Ansteuerschaltung CON oder unter Umständen sogar aus der integrierten Schaltung IC zu erhalten. Eine weitere Möglichkeit zur Gewinnung der Frequenz fr, die vorteilhaft dann eingesetzt wird, falls Beam-blanking-Generator und Ansteuerschaltung CON nicht aufeinander synchronisiert sind, wird später beschrieben.

In den Fällen, in denen eine Synchronisation des Beam-blanking-Generators BBG und der Ansteuerschaltung CON untereinander nicht möglich ist, gibt es für die in Figur 2 dargestellte Vorrichtung die Möglichkeit, ein Referenzsignal der Frequenz fr über einen Mischer und einen Tiefpaß zu gewinnen. Hierbei wird der Mischer zum einen mit der Ansteuerschaltung CON zum anderen mit dem Beam-blanking-Generator BBG verbunden. Die Gewinnung der Frequenz fr erfolgt analog zu der Frequenz df des Sekundärelektronensignals SE.

Figur 5 zeigt eine ebenfalls aus Amplituden- AD, Phasendemodulator PD' und Bandpaß BP bestehende Meßverarbeitungsanordnung MV'''' wie in Figur 4, jedoch ist der Phasendemodulator PD' nicht wie in Figur 4 am Ausgang sondern am Eingang des Bandpaßfilters BP angeschlossen.

Für sog. quantitative Messungen kann in einem Rasterelektronen mikroskop nach der Figur 2 ein Spektrometer SP angeordnet werden, wie es beispielsweise aus der US-PS 4 292 519 bekannt ist. Insbesondere kommt dafür ein Gegenfeldspektrometer in Betracht. Dabei wird das Spektrometer vorzugsweise in einer Rückkopplungsschaltung betrieben.

Die Verwendung eines Spektrometers SP in der Vorrichtung nach Figur 2 ist nicht nur zur Spannungsmessung nützlich. Benutzt man keine Rückkopplungsschleife, sondern legt an das Gegenfeldnetz eines Gegenfeldspektrometers eine konstante Spannung, so werden nur Sekundärelektronen mit einem Potential, das über der der Gegenfeldelektrode liegt, durchgelassen. Dadurch werden Störeinflüsse lokaler Felder unterdrückt.

Da es sich bei dem zu messenden Signal am jeweiligen Meßort um ein periodisches Signal handelt, weist sein Spektrum nur Spektralanteile bei der Grundfrequenz und deren Oberwellen auf, d.h. es handelt sich nicht um ein kontinuierliches, sondern um ein diskretes Spektrum. Zur Bestimmung des Spektrums genügt es daher, nur die Spektralanteile bei der Grundfrequenz und deren Oberschwingungen mit Hilfe der beschriebenen Meßanordnungen zu messen. Ein vollständiges Durchfahren des gesamten interessierenden Frequenzbereiches ist zwar möglich, aber keineswegs erforderlich, wodurch sich eine erhebliche Reduktion der Meßzeit erreichen läßt. Der jeweils auszufilternde und zu messende Spektralanteil wird durch die Wahl der Frequenz fb, mit der der Primärstrahl moduliert wird, bestimmt. Will man also nur Spektralanteile bei diskreten Frequenzwerden messen, so genügt es, die Frequenz fb auf die diesen Frequenzwerten gemäß der Mischbedingung zugeordneten Werte einzustellen.

Die Mischung auf eine feste Zwischenfrequenz beruht auf einem multiplikativen Zusammenhang. In dem dargestellten Fall ist der mit Hilfe des Detektors detektierte Sekundärelektronenstrom nämlich zum einen proportional zum Primärelektronenstrom und hängt zum anderen durch den Potentialkontrasteffekt vom jeweiligen Signal am Meßort ab. Zur Mischung auf eine feste Zwischenfrequenz wird daher unter Ausnutzung dieses multi plikativen Zusammenhangs der Primärelektronenstrahl in seiner Intensität moduliert. Eine Mischung auf eine niedrige feste Zwischenfrequenz kann man aber ebenfalls erreichen, wenn man anstelle der Primärelektronen die Sekundärelektronen bzw. den Sekundärelektronenstrahl in ihrer Intensität moduliert. Dies ist beispielsweise möglich, indem man die Energieschwelle eines Gegenfeldspektrometers mit der Frequenz fb moduliert. Durch Berücksichtigung der Spektrometerkennlinie kann man sogar eine sinusförmige Modulation des Sekundärelektronensignals erreichen, und so eventuelle Schwierigkeiten mit Kreuzmodulationsprodukten, wie sie bei den beschriebenen Verfahren u.U. auftreten, da die Primärelektronen beispielsweise auch mit Rechtecksignalen gepulst werden können, zu vermeiden. Durch die höheren umzuladenden Kapazitäten und die Energiedispersion der Sekundärelektronen ist die Grenzfrequenz beim Pulsen einer Einrichtung in der Signalverarbeitung geringer. Außerdem wird durch das Spektrometer das Gesichtsfeld eingeengt. Analog kann man auch in den Photomultiplier zusammen mit einer Gateschaltung betreiben oder im Videosignalpfad modulieren oder den Photomultiplier selbst zur Modulation benutzen. In diesem Fall wird die Bandbreite allerdings durch den Zintillator des Detektors stark eingeschränkt.

Da eine rein sinusförmige Modulation des Primärelektronenstroms PE im allgemeinen nicht möglich ist, kann es zu Meßfehlern durch Beiträge von Oberwellen und unterschiedliche Amplituden der Grundschwingung kommen. Dies kann aber beim gemessenen Spektrum berücksichtigt und gegebenenfalls korrigiert werden. Hierfür muß der Primärelektronenstrom im Frequenzbereich H(w) entweder theoretisch berechnet oder gemessen werden. Eine Möglichkeit dazu besteht darin, anstelle des unbekannten Signals f(t) der Probe ein bekanntes Signal (beispielsweise eine reine Sinusschwingung) im Frequenzbereich zu messen. H(w) ist dann aus der Division von G(w) durch F(w) zu bestimmen. Ist der Primärelektronenstrom im Frequenzbereich H(w) bekannt, muß vor jeder Fourier-Rücktransformation im Rechner R eine Division des gemessenen Wertes G(w) durch den Wert H(w) erfolgen. Da es sich auch hier wieder nur um periodische Signale handelt, kann die Bestimmung des Spektrums H(w) und die Korrektur des gemessenen Spektrums G(w) auf diskrete Frequenzwerte beschränkt werden.

Nur selten werden die Signale im Inneren der integrierten Schaltung IC einen rein sinusförmigen Verlauf aufweisen. Ebenso wird man nur selten eine rein sinusförmige Modulation des Primärstrahls PE, wie oben bereits erwähnt, erreichen können oder wollen. Daher enthalten sowohl das Signal der Probe IC als auch der Primärstrahl PE Oberschwingungen. Selbstverständlich kann man zur Mischung auf eine feste Zwischenfrequenz df nicht nur die Grundschwingungen sondern auch die höheren Harmonischen der Frequenzen ausnutzen. Die Zwischenfrequenz df kann also ganz allgemein dem Absolutbetrag der Summe oder Differenz der Grundfrequenz des Signals in der Probe IC oder einem ganzzahligen Vielfachen davon und der Grundfrequenz des Primärstrahls oder einem ganzzahligen Vielfachen davon entsprechen. Besonders vorteilhaft ist es beispielsweise, mit den Oberschwingungen des Primärstrahls zu arbeiten, wenn der Generator BBG nur eine niedrige Grundfrequenz aufweist.

Natürlich können anstelle des Potentialkontrasts auch andere Wechselwirkungen ausgenutzt werden. Dazu zählt beispielsweise die Beeinflussung der von einem Primärelektronen- bzw. Laserstrahl erzeugten Sekundär- bzw. Photoelektronen durch ein magnetisches Feld. Durch Ausnutzung dieses sog. "magnetischen Kontrasts" ließe sich etwa die Bewegung magnetischer Domänen in Magnetblasenspeicher untersuchen.

Der Primärstrahl muß keineswegs ein Partikelstrahl sein, sondern kann auch aus einer beliebigen Strahlung bestehen. Benutzt man etwa einen Laserstrahl als Primärstrahl PE und wiederum eine integrierte Schaltung als Probe IC, so kann über Laserstrahl in den pn-Übergängen der Probe IC Elektronen-Lochpaare und damit freie Ladungsträger erzeugen. Dies macht sich dann in einer Änderung der Stromaufnahme der Probe IC bemerkbar. Wie groß diese Änderung ist, hängt auch vom Schaltzustand des jeweiligen pn-Übergangs ab. Eine periodische Änderung des Schaltzustandes eines pn-Übergangs ließe sich daher leicht durch eine Messung des Versorgungsstromes der Probe IC feststellen. Der Versorgungsstrom der Schaltung bzw. seine Differenz zum Ruhestrom kann in diesem Falle unmittelbar als Meßsignal dienen, ein besonderer Detektor ist nicht unbedingt erforderlich.

## Ansprüche

1. Verfahren zur Spannungsmessung mit einer Elektronensonde zur zeitlichen Detektion und/oder qualitativen und/oder quantitativen Abbildung eines Punktes einer Probe, der ein Signal wenigstens einer bestimmten Frequenz (fs) führt, mit Hilfe eines Mikroskops, indem der Punkt mit einem Primärstrahl (PE) beaufschlagt wird, wobei von dem Punkt ein sekundäres Signal, insbesondere über einen Detektor (DT) abgeleitet und gegebenenfalls zu einem Meßsignal weiterverarbeitet wird, daß der Primärstrahl (PE) oder eine Einrichtung zur Signalverarbeitung oder die Energieschwelle eines Spektrometers (SP) mit einer weiteren, insbesondere einstellbaren Frequenz (fb) moduliert wird, wobei diese Frequenz (fb) verschieden ist von der bestimmten Frequenz (fs), daß dadurch das sich ergebende sekundäre Signal oder Meßsignal auf eine bestimmte Zwischenfrequenz (df) gemischt wird, **dadurch gekennzeichnet,** daß aus dem sekundären Signal oder dem Meßsignal über eine Meßverarbeitungsanordnung (MV) zwei erste, für die vollständige Beschreibung eines Signals im Zeitbereich erforderlichen zwei Merkmale eines Signals im Frequenzbereich gewonnen werden und daß anschließend über eine Fourier-Rücktransformation der zwei Merkmale des Signals der zeitliche Verlauf des sekundären Signals oder des Meßsignals gewonnen wird.

2. Verfahren nach Anspruch 1, **dadurch gekennzeichnet,** daß die zwei Merkmale eines Signals das Betrags- und Phasenspektrum bilden.

3. Verfahren nach Anspruch 1, **dadurch gekennzeichnet,** daß die zwei Merkmale eines Signals die zwei Quadraturkomponenten des Signals sind.

4. Verfahren nach Anspruch 3, **dadurch gekennzeichnet,** daß die zwei Quadraturkomponenten der Real- und Imaginärteil des Signals sind.

5. Verfahren nach einem der Ansprüche 1 bis 4, **dadurch gekennzeichnet,** daß das sekundäre Signal und/oder das Meßsignal aus einem elektrischen Signal besteht.

6. Verfahren nach einem der Ansprüche 1 bis 5, **dadurch gekennzeichnet,** daß bei periodischen sekundären Signalen das Spektrum im Frequenzbereich nicht kontinuierlich, sondern an diskreten Frequenzen gemessen wird.

7. Verfahren nach Anspruch 6, **dadurch gekennzeichnet,** daß die diskreten Frequenzen die Grundfrequenz und/oder deren Vielfache sind.

8. Verfahren nach einem der Ansprüche 1 bis 7, **dadurch gekennzeichnet,** daß der Primärstrahl (PE) wiederholt über eine Gruppe von mehreren Punkten hinweg abgelenkt wird, daß die einstellbare Frequenz (fb) dabei variiert wird, wobei ihre Änderungsgeschwindigkeit klein ist gegenüber der Ablenkgeschwindigkeit des Primärstrahls (PE).

9. Verfahren nach einem der Ansprüche 1 bis 7, **dadurch gekennzeichnet,** daß der Primärstrahl (PE) auf einen einzigen Punkt gerichtet wird, daß dabei die einstellbare Frequenz (fb) variiert wird und daß dieser Vorgang gegebenenfalls auf einem oder mehreren Punkten sukzessiv wiederholt wird.

10. Verfahren nach einem der Ansprüche 1 bis 9, **dadurch gekennzeichnet,** daß falls ein Signal mit der einstellbaren Frequenz (fb) keine Sinusform aufweist, zunächst das zur einstellbaren Frequenz (fb) gehörende Signal H(w) im Frequenzbereich bestimmt wird, wobei zwei Korrekturwerte errechnet werden, daß vor der Fourier-Rücktransformation der zwei Merkmale des Signals diese durch die zwei Korrekturwerte dividiert werden.

11. Verfahren nach Anspruch 10, **dadurch gekennzeichnet,** daß das zur einstellbaren Frequenz (fb) gehörende Signal H(w) im Frequenzbereich so bestimmt wird, daß der Probe ein bekanntes Signal einer bestimmten Frequenz (fs) zugeführt wird, daß das bekannte Signal in den Frequenzbereich transformiert wird, daß das sekundäre Signal im Frequenzbereich gemessen wird, daß eine Division des im Frequenzbereich vorliegenden sekundären Signals oder Meßsignals durch das im Frequenzbereich vorliegende bekannte Signal durchgeführt wird.

12. Vorrichtung zur zeitlichen Detektion und/oder qualitativen und/oder quantitativen Abbildung eines Punktes einer Probe, der ein Signal wenigstens einer bestimmten Frequenz (fs) führt, mit Hilfe eines Mikroskops, mit einer Primärstrahlquelle zur Emission eines Primärstrahls (PE), mit einer Signalkette zur Verarbeitung eines sekundären Signals, das von dem Punkt abgeleitet wird, insbesondere in ein elektrisches Meßsignal, wobei die Signalkette gegebenenfalls einen Detektor (DT) aufweist, mit einem Generator (BBG) zur Ansteuerung eines Modulationssystems (BBS) zur Modulation des Primärstrahls (PE) oder zur Modulation einer Einrichtung zur Signalverarbeitung oder zur Modulation der Energieschwelle eines Spektrometers (SP) mit einer weiteren, insbesondere einstellbaren Frequenz (fb), die von der bestimmten Frequenz (fs) abweicht, mit einer Ansteuerschaltung (CON), die mit der Probe verbunden ist, **dadurch gekennzeichnet,** daß in der Signalkette eine Meßverarbeitungsanordnung (MV') enthalten ist, die die zwei Merkmale eines Signals bei der Zwischenfrequenz (df) bestimmt, daß mindestens ein Ausgang der Meßverarbeitungsanordnung (MV) mit einem Rechner verbunden ist.

13. Vorrichtung nach Anspruch 12, **dadurch gekennzeichnet,** daß die Meßverarbeitungsanordnung (MV″, MV‴) einen Bandpaßfilter (BP) eingangsseitig zum Ausfiltern eines Signals mit einer Zwischenfrequenz (df) aus dem sekundären Signal oder Meßsignal enthält.

14. Vorrichtung nach Anspruch 13, **dadurch gekennzeichnet,** daß die Meßverarbeitungsanordnung (MV″, MV‴) einen Amplituden- (AD) und einen Phasendemodulator (PD, PD') enthält, daß der Amplitudendemodulator (AD) hinter dem Bandpaßfilter (BP) angeordnet ist, daß ein Ausgang des Amplituden- (AD) und ein Ausgang des Phasendemodulators (PD, PD') mit einem Rechner (R) verbunden ist.

15. Vorrichtung nach Anspruch 14, **dadurch gekennzeichnet,** daß der Phasendemodulator (PD) parallel zum Amplitudendemodulator (AD) geschaltet ist.

16. Vorrichtung nach Anspruch 14, **dadurch gekennzeichnet,** daß der Phasendemodulator (PD) parallel zum Bandpaßfilter (BP) geschaltet ist.

17. Vorrichtung nach einem der Ansprüche 14, 15 oder 16, **dadurch gekennzeichnet,** daß dem Phasendemodulator (PD, PD') ein Referenzsignal mit der Frequenz (fr) zugeführt wird.

18. Vorrichtung nach Anspruch 12, **dadurch gekennzeichnet,** daß die Meßverarbeitungsanordnung (MV') aus einem Lock-in-Verstärker (LI) besteht, dem ein Referenzsignal mit der Frequenz (fr) zugeführt wird.

19. Vorrichtung nach Anspruch 12, **dadurch gekennzeichnet,** daß die Meßverarbeitungsanordnung mindestens einen phasenempfindlichen Detektor enthält, dem ein Referenzsignal mit der Frequenz (fr) zugeführt wird.

20. Vorrichtung nach einem der Ansprüche 17, 18 oder 19, **dadurch gekennzeichnet,** daß der Generator (BBG) mit einer Ansteuerschaltung (CON) und ein Frequenzteiler (FP) mit einem von beiden verbunden ist, daß der Frequenzteiler (FP) ein Referenzsignal mit der Frequenz (fr) liefert.

21. Vorrichtung nach einem der Ansprüche 17, 18 oder 19, **dadurch gekennzeichnet,** daß der Generator (BBG) und die Ansteuerschaltung (CON) mit jeweils einem Eingang einer Mischstufe und nachgeschaltetem Filter verbunden sind, daß ein Filterausgang ein Referenzsignal der Frequenz (fr) liefert.

22. Vorrichtung nach einem der Ansprüche 12 bis 21, **gekennzeichnet durch** ein Spektrometer (SP) zur quantitativen Messung des sekundären Signals.

23. Vorrichtung nach Anspruch 22, **dadurch gekennzeichnet,** daß das Spektrometer (SP) ein Gegenfeldspektrometer ist.

24. Vorrichtung nach Anspruch 22, **dadurch gekennzeichnet,** daß das Spektrometer (SP) als Gegenfeldspektrometer mit einer konstanten Spannung an der Gegenfeldelektrode ausgebildet ist.

# FIG 1

$$f(t) \quad \circ\!\!-\!\!\bullet \quad G(w) = H(w) \cdot F(w)$$

$$g(t) = h(t) * f(t)$$

$$F^{-1}[G(w)]$$

$$g(t)$$

# FIG 2

**FIG 3**

MV'

df ——————— [ LI ] ———————

|fr

**FIG 4**

MV"

df ——— [ BP ≈ ] ———•——— [ AD ] ———

[ PD ]

|fr

**FIG 5**

MV'''

df ——•——— [ BP ≈ ] ——— [ AD ] ———

[ PD' ]

|fr